# EUROPEAN PATENT SPECIFICATION

(11) **EP 2 185 976 B1**
(45) Date of publication and mention of the grant of the patent: **24.04.2013**
(21) Application number: 07872109.9
(22) Date of filing: 07.09.2007
(51) Int. Cl.: G03F 7/016, G03F 7/021

(54) **PHOTOSENSITIVE COMPOSITIONS CONTAINING POLYVINYL ALCOHOL AND THEIR USE IN PRINTING PROCESSES**
LICHTEMPFINDLICHE ZUSAMMENSETZUNGEN MIT POLYVINYLALKOHOL UND IHRE VERWENDUNG FÜR DRUCKVERFAHREN
COMPOSITIONS PHOTOSENSIBLES CONTENANT DE L'ALCOOL POLYVINYLIQUE ET LEURS UTILISATION DANS DES PROCÉDÉS D'IMPRESSION

(43) Date of publication of application: 19.05.2010
(73) Proprietor: Kiian S.p.A. Socio Unico, 22070 Luisago (CO) (IT)
(72) Inventor: BERETTI, Vittorio, I-22074 Lomazzo (Como) (IT); LOSTRITTO, Angela, I-81022 Casagiove (Caserta) (IT); GALIMBERTI, Maurizio Stefano, I-20133 Milano (IT); FATTORINI, Franco, I-22020 Cavallasca (Como) (IT)
(74) Representative: Gislon, Gabriele
(86) International application number: PCT/IT2007/000621
(87) International publication number: WO 2009/031174

(56) References cited:
- EP-A- 0 252 150
- EP-A- 0 373 862
- WO-A-85/04028
- GB-A- 1 378 861
- GB-A- 2 194 070
- US-A1- 2002 058 589

## Description

The present invention concerns photosensitive compositions containing polyvinyl alcohol and their use in printing processes. More specifically, the invention concerns photosensitive compositions based on polyvinyl alcohol (PVA) for the preparation of rotary printing cylinders intended mainly, but not exclusively, for the prinking of fabrics.

Photosensitive compositions are widely used for the preparation of cylinders and clichés for rotary printing; they comprise resins which, due to the action of so-called photosensitive compounds, polymerise when exposed to light with suitable wavelength, in general ultraviolet light. By exposing to the UV light only the part of the support on which the photosensitive composition has been applied, only the exposed part is polymerised and the non-polymerised part can subsequently be removed from the support to produce an inking area.

WO 85/04028 discloses the preparation of a screen printing stencil composition comprising an aqueous dispersion of a water insoluble addition copolymer, a water soluble colloid (such as PVA) and a photosensitiser, which is capable of insolubilising said water soluble colloid. The sensitisers include azides, diazonium compounds, nitro compounds, styryl compounds and dichromate GB 1378861 relates to light-sensitive copying composition containing as essential constituents at least one condensable aromatic diazonium salt, at least one water-soluble polymeric binder (PVA) free from cross-linking groups and at least one substance capable of cross-linking the binder in the presence of said diazonium salt under the influence of light.

EP0252150 relates to a photosensitive resin composition for screen process comprising a film-forming polymer compound, a photo-crosslinkable PVA having at least one photo-cross-linkable structural unit, and a diazo compound.

Compositions containing polyvinyl alcohol (PVA) used in the field of rotary printing of textile products are known in particular. In rotary printing, the print matrix used, i.e. the support on which the design to be printed on the fabric is created consists of a micro-perforated metal cylinder. The micro-holes have the function of allowing the ink inside the cylinder to pass through.

The cylinder is firstly thermoformed to guarantee that the section is perfectly circular, then degreased (with soaps) to clean the surface in order to facilitate perfect adhesion of the photosensitive composition which is then applied. The role of the photosensitive composition is to selectively close some holes of the cylinder so as to permit passage of the ink from the inside of the cylinder to the outside only via the non-closed holes which constitute the print design. In rotary textile printing, there are as many cylinders as colours to be deposited on the fabric.

According to the known technique, a photosensitive composition for the preparation of cylinders for rotary textile printing consists of two components, one component being represented by the emulsion and the other by the sensitizer. Mixing of the two components produces the photosensitive composition used for preparation of the cylinder.

After mixing the two components by means of a doctor, the photosensitive composition is spread on the cylinder and fills the micro-holes. This operation is performed vertically by means of an up-down movement or vice versa, at a speed of between 0,067 m/s and 0,01 m/s.

The cylinder is then dried in a forced ventilation oven for 1 hour at a temperature between 25 and 35°C.

When the cylinder with the emulsion is dried and is substantially free from humidity, it is engraved, with a source of ultraviolet light, by placing the design to be reproduced between the light and the cylinder, or by means of a photographic film or by spraying wax using the inkjet technology.

After irradiation with the ultraviolet light, the emulsion which has been protected from the radiation (by the photographic film or the wax) is removed by Washing with water at ambient temperature.

To give the cylinder the final characteristics of chemical-mechanical resistance, necessary for the printing phase, it is treated for 1 hour at a temperature of 180-200°C.

After treatment, the emulsion is insoluble in both water and organic solvents, due to the cross-linking: that has occurred between the resins, and therefore becomes inert with respect to the components of the print pastes and inks.

Below is a typical percentage composition in weight of the various compounds that form the photosensitive composition:

| Component A - component based on PVA and resins: | | |
|---|---|---|
| | Solution of polyvinyl alcohol (PVA) in water | 35% to 55% |
| | Epoxy resin solution in solvent | 10% to 25% |
| | Urea-formaldehyde or benzoguanaline resin | 10% to 25% |
| | Alkyd resin in solvent | 10% to 25% |
| | Pigment | 0.1% to 1% |
| | Additives (antifoaming-distening-wetting agents) | 0.5% to 5% |

| Component B- sensitizer component | |
|---|---|
| Sodium or potassium or ammonium dichromate | 10% to 20% |
| Water | 80% to 90% |

Component B (sensitizer component) is added to component A (emulsion/solution of resins in water) in a ratio between 7 and 15% in weight and preferably component B is 10% in weight of component A.

The polyvinyl alcohol acts as emulsifying agent and protective colloid.

The polymeric synthetic resins have the function of making the emulsion print-resistant, after treatment at high temperature.

The function of the chromium compound is to oxidise the polyvinyl alcohol and to form a complex with the polyvinyl alcohol itself which in this way is cross-linked by the chromium and therefore becomes insoluble. The efficiency of the chromium compound for cross-linking of the polyvinyl alcohol, and therefore for its insolubility, is known, and said compound is used for this reason.

The known technique described above has the problem, however, of high toxicity of the hexavalent chromium which has been recognised as a carcinogenic agent for man. This fact results in a series of problems with handling of the photosensitive composition (A+B) and with disposal of the composition washed away from the cylinder or other supports, containers and equipment after irradiation with UV light. Furthermore, the limitations deriving from the use of chromium have substantial restricted use of the PVA-based composition discussed above to rotary printing of textile products.

The object of the present invention is to solve the above problem and provide a photosensitive composition that can be used without involving a toxic substance like hexavalent chromium.

Another object of the present invention is to simplify the production cycle for realisation of the cylinders for rotary textile printing.

These objects are achieved by means of the present invention, which concerns a photosensitive composition containing polyvinyl alcohol, characterised according to claim 1.

The invention furthermore concerns a process for preparation of the photosensitive composition discussed above, as claimed in claim 3, the use of said composition according to claim 14, a rotary printing cylinder as claimed in claim 15, which is partially provided with a polymerised coating as obtainable from the composition according to claim 1 and the use of the printing cylinder for the printing of textile products as claimed in claim 16.

It has surprisingly been found that it is possible to eliminate the dichromate from the formulation of the photosensitive composition and replace it with three different compounds, two of which form a new "component B", thus obtaining photosensitive compositions which achieve the technical objectives for rotary printing.

In the present invention, elimination of the chromium compounds has been obtained via use of the following formulation for the "component B":
- photosensitive organic compound
- gelling agent
- polyvinyl alcohol cross-linking agent

The chromium compound was therefore replaced with a mixture of the following two ingredients: gelling agent, photosensitive organic compound. The third component necessary for replacing the dichromate is a cross-linking agent for the polyvinyl alcohol, which is added to the component A".

The three ingredients must be used together, i.e. all three must be present in the final formulation.

The cross-linking agent for the PVA binds, when hot, with the PVA and significantly reduces its solubility. Suitable compounds are, for example, alkylated melamines, i.e. methylated, butylated, isobutylated melamines. Examples of suitable compounds are methoxymethyl methylolmelamine (Cymel 385 by Cytec). Other suitable compounds are the imino melamines; alkylated, methylated, butylated ureic resin, for example: isobutoxymethyl methylol urea (Cymel UI20E by Cytec), benzoguanamine resin for example (Cymel 1123 by Cytec), glycol uryl compounds, for example tetramethylol glycol uryl (Cymel 1172 by Cytec).

The preferred cross-linking agent is iso-butoxymethyl methylol urea.

The gelling agent during the hot cross-linking reaction gives the system the necessary insolubility to withstand the deteriorating action of the printing. The preferred agent is aluminum sulphate.

The photosentive organic compound has the function of making the photosensitive composition sensitive to ultraviolet light and therefore of permitting hardening of the photosensitive composition, which will occur selectively only in the holes exposed to the light.

Suitable photosensitive organic compounds are SBQ, diazo sulphates and diazo phosphates, if necessary in combination with cobalt or zinc chloride. The preferred agent is represented chemically by a diazo sulphate. A mixture of these salts can also be used. The diazo sulphate compounds are obtained by hot condensation of the diazo diphenylamine with HCHO in sulphuric acid and have CAS number 41432-19-3.

Further examples of compounds suitable for the invention are listed below in Table 1 with their trade name and name of the supplier.

**Table 1**

| | TRADE NAME | | SUPPLIER |
|---|---|---|---|
| | | | |
| Polyvinyl alcohol | Mowiol™ 18-88 | | Clariant |
| | Gosenol™ | « | Nippon Gohsei |
| | Poval™ | « | Kuraray |
| | Polyviol™ | « | Polyvert |
| | | | |
| Epoxy resin | Epikote™ 1001 | | Shell |
| | AralditeGZ 7071 | | Ciba |
| | NPES™ 301 | | Warwik Massa |
| | | | |
| Cross-linking agent Cymel™ 385 (alkylated melamine) | | | Cytec |
| | 1172 (glycol uryl compound) | | " |
| | UI 20 E (ureic) | | " |
| | Itamin™ HM3 | | Galstaff Multiresine |
| | Viamin™ HP308 | | Carin |
| | | | |
| Alkyd resin | Benasol™ RC45 | | Benased |
| | Uralac™ OR 318 | | DSM |
| | | | |
| Gelling agent | Glyoxal | | Sigma |
| | Glutaraldehyde | | |
| | Ammonium zirconium carbonate | | Alkital |
| | Sodium borate | | |
| | Aluminium sulphate | | |
| | Ammonium sulphate | | |
| | Hydrochloric acid | | |
| | Alum | | |
| Photosensitive organic compounds | | | |
| | SBQ | Photosensitive materials PCAS | |
| | Diazo sulphate | Photosensitive materials PCAS | |
| | Diazo phosphate | Photosensitive materials PCAS | |
| | Diazo sulphate+cobalt | Photosensitive materials | |
| | Diazo sulphate+zinc chloride | " | |

According to a preferred aspect of the invention, the photosensitive composition, accounts for the following weight percentages of the final composition, i.e. the composition to be applied to the cylinder;

| | |
|---|---|
| *Solution of polyvinyl alcohol in water* | *25% to 60%* |
| *Epoxy resin solution in polar solvent* | *10% to 25%* |
| *Alkyd resin* | *5% to 20%* |
| *Cross-linking agent for PVA* | *5% to* 20% |
| *Gelling agent* | *0.2% to 3%* |
| *pH modifier* | *0.5% to 5%* |
| *Photosensitive organic-compound* | *0.3% to 2%* |

The pH modifier is preferably a bicarbonate buffer or, alternatively, a basic salt of alkaline metal and has the function of maintaining the pH of the final composition at a neutral or slightly basic value, in the interval between 6.5 and 8.0, preferably 6.5 and 7.5. At this pH, the pot life of the composition is improved, reaching 7 days with respect to the 12 hours of the known dichromate based compositions.

In comparison with the chromium formulation, the gelling agent in the latter would be superfluous, the diazonium salt could not be used as it would interfere with the chromium and the cross-linking agent would clearly be superfluous as the function is performed by the chromium.

The invention has numerous advantages with respect to the known art.

Firstly it allows chromium-free compositions to be used, with all consequent environmental advantages, furthermore it allows a cross-linked resin to be obtained able to provide very accurate inking (and printing) areas which are resistant to the inks used and to the wear of the printing process.

An unexpected advantage is the considerable increase in pot life of the photosensitive composition ready for use, i.e. obtained by mixing of the components A and B before irradiation with UV light. It was found that the pot life of the end product increases from approximately 1 day (24 hours) to 15 days and that the pot life as cylinder provided with a layer of photosensitive composition, before exposure to the UV light, increases from approximately 12 hours to 7 day.

Preferably, in the composition of the invention, out of the total weight of the final composition, the *polyvinyl alcohol* is in the form of a solution in water from 12% to 35% and said solution is present in a range of between 25% and 70%, preferably between 35% and 60% and more preferably between 45% and 55%, the *epoxy resin* is in the form of a'solution in organic solvent from 60% to 80% and said solution is present in a range from 10% to 25%, preferably from 15% to 25% and more preferably from 18% to 22%, the *alkyd resin* is in the form of a solution in organic solvent from 40% to 60% and said solution is present in a range from 5% to 20%; preferably from 5% to 15%, the *cross-linking agent* is in a range from 3% to 20%, preferably from 5% to 15%, the *gelling agent* is in a range from 0.1% to 2%, Preferably from 0.2% to 1%; the *pH* modifier is in a range from 0.5% to 5%, preferably from 2% to 4%, the *demineralised water* is in a range from 3% to 20%, preferably 7% to 15%; the photosensitive *organic compound* is in a range from 0.1 % to 2%, preferably 0.2% to 1%.

Further characteristics and advantages of the present invention are given in the following examples which illustrate the preparation of a reference composition according to the known art and a composition according to the present invention.

### Example 1-Reference composition (known art)

The following ingredients are placed in a 250 ml vessel one after the other, at ambient temperature, continuously agitating the mixture that forms (the quantities are indicated in grams):

| | |
|---|---|
| Polyvinyl alcohol 18-88¹ | 50 |
| Water | 10 |

40 grams of a mixture consisting of the following ingredients are added to the above:

| | |
|---|---|
| Epoxy resin² | 20 |
| Benzoguanamine-formaldehyde resin³ | 10 |
| Urethane alkyd resin⁴ | 10 |
| Suspension of silica⁵ | 1.5 |
| Blue pigment⁶ | 0.4 |
| Fluorinated surface-active agent⁷ | 0.1 |

The products used are listed here with references:
*1) 15% solution in water of Mowiol 18-88 (Clariant)*
*2) 75%, solution in xylene of Epikote 1001 (Shell)*
*3) Maprenal MF 980*/*62B (Vianova Resins)*
*4) Uralac OR 318X50 (DSM) 50% solution in xylene*
*5) Sillitin Z (Spica): mixture of silica and kaolinite, 60% suspension in H₂O*
6) *Blu neoprint LBS (Lamberti) Water paste with blue pigment*
*7) Fluorolink 7005 (Solvay Solexis). Non-ionic Fluoropolyether surface-active agent.*

10 grams of a dichromate solution consisting of 1 gram of potassium dichromate in 9 grams of water are then added to the mixture of the reference example.

### Example 2- Composition of the invention

As in Example 1, the following ingredients are placed in a 250 ml vessel one after the other, at ambient temperature, continuously agitating the mixture that forms (the quantities are indicated in grams):

| | |
|---|---|
| Polyvinyl alcohol 18-88¹ | 50 |
| Water | 10 |

40 grams of a mixture consisting of the following ingredients are added to the above:

| | |
|---|---|
| Epoxy resin² | 20 |
| Cross-linking agent³ | 10 |
| Urethane alkyld resin⁴ | 10 |
| Suspension of silica⁵ | 1.5 |
| Blue pigment⁶ | 0.4 |
| Fluorinated surface-active agent⁷ | 0.1 |

The materials used are indicated below with the corresponding reference numbers:
*1) 15% solution in water of Mowiol 18-88 (Clariant)*
2) *75% solution in xylene of Epikote 1001 (Shell)*
*3 Iso-butoxymethyl methylol urea, Cymel UI 20E (Cytech)*
*4) Uralac OR 318X50 (DSM) 50% solution in xylene*
*5) Sillitin Z (Spica): mixture of silica and kaolinite; 60% suspension in H₂O*
*6) B*/*u neoprint LBS (Lamberti) Water paste with blue pigment*
*7) Fluorolink 7005 (Solvay Solexis). Non-ionic fluoropolyeter surface-active agent.*

5.9 grams of an aqueous solution consisting of the following are then added to the mixture of the example of the invention, again at ambient temperature and under continuous agitation:

| | |
|---|---|
| Diazo sulphates | 0.4 |
| Aluminium sulphate | 0.5 |
| Water | 5 |

The diazo sulphates used are one or more diazonium salts salts: in particular the condensation product of the diazodiphenylamine sulphate with formaldehyde (HCHO) in sulphuric acid and the condensation product of the 4- diazodiphenylamine sulphate (HCHO) in phosphoric acid.

### Comparison of results

The comparison between some important characteristics of the compositions obtained acccording to Examples 1 an 2 is given below in Table 2.

**Table 2**

| | Reference composition (prior art) | Composition of the invention |
|---|---|---|
| Emulsion labelling (Hazard symbols) | With symbols (Irritant Xi) | No symbols |
| Sensitizer agent labelling | TOXIC (Mutagenic) | IRRITANT |
| Disposal (Process waste) | Preventive abatement Chromium VI to Chromium III before being taken to waste treatment plant | can be taken directly to waste treatment plant |
| Product pot life (Emulsion + sensitizer agen) | 24 hours | days |

In addition to the various advantages intrinsically connected with elimination of the chromium, it can be noted that the composition of the invention also has a significantly longer pot life compared to the prior art.

With the compositions of Examples 1 and 2, two series of rotary print cylinders were produced having the characteristics given below in Table 3.

| | Print cylinders produced with the reference composition (prior art) | Print cylinders produced with the composition of the invention |
|---|---|---|
| Pot life of cylinder with photosensitive composition (before engraving and development) | 12 hours | 7 days |
| Graphic accuracy of design reproduced | 4 | 5 |
| Resolubilisation (Development with water after engraving) | 4 | 5 |
| Chemical resistance | 5 | 5 |
| Mechanical resistance | 4 | 5 |
| Use | Standard consolidated | Unchanged |
| Cost | Consolidated | Aligned with standard |

The scale of values ranges from 1 (very poor) to 5 (excellent).

The following Table 4 shows further formulations of compositions according to the prior art (reference example 3) and according to the present invention.

**Table 4**

| 1st STEP PREPARATION OF THE EMULSION | | | | |
|---|---|---|---|---|
| INGREDIENTS | 3 | 4 | 5 | 6 |
| | | | | |
| Polyvinyl alcohol 18-88 | 50 | 50 | 50 | 50 |
| Demineralised water | 7.5 | 6 | 5.5 | 5 |
| Mixture | 40 | 40 | 40 | 40 |
| consisting of: | | | | |
| Epoxy resin | 20 | 20 | 25 | 20 |
| Cross-linking agent for PVA | 0 | 5 (1) | 10 (2) | 10 (3) |
| Benzoguanamine-formaldehyde resin | 10 | 0 | 0 | 0 |
| Urethane alkyd resin | 10 | 15 | | 10 |
| Suspension of silica | 1.5 | 1.5 | 5 | 1.5 |
| Blue pigment | 0.4 | 0.4 | 0.4 | 0.4 |
| Fluorinated surface-active agent | 0.1 | 0.1 | 0.1 | 0.1 |
| Basic salt, in aqueous solution | 0.5 | 2 | 2.5 | 3 |

| 2nd STEP COMPLETION | | | | |
|---|---|---|---|---|
| INGREDIENTS | 3 | 4 | 5 | 6 |
| | | | | |
| Sodium dichromate | 1 | 0 | 0 | 0 |
| Diazo sulphate | 0 | 0 | 0 | 0.4 |
| Diazo phosphate | 0 | 0.4 | 0 | 0 |
| Diazo sulphate + zinc chloride (4) | 0 | 0 | 0 | 0 |
| Diazo sulphate cobalt (5) | 0 | 0 | 0 | 0 |
| SBQ | 0 | 0 | 1 | 0 |
| Aluminium sulphate | 0 | 0.3 | 0.8 | 0.5 |
| Demineralised water | 9 | 9.1 | 8.2 | 9.1 |

| | | | | |
|---|---|---|---|---|
| (1) Alkylated melamine (Cymel 385) (2) Glycol uryl compound (Cymel 1172) (3) Ureic resin (UI 20 E) (4) FSPO Diazo sulphate + zinc chloride as complexing agent (5) FSCO Diazo sulphate + cobalt as complexing agent | | | | |

The above compositions were used to produce print cylinders according to the following example.

### Example 7. Production of micro-perforated cylinders for rotary textile printing.

The diazo sensitizer, previously diluted with demineralised water according to the second step listed above, is added to the emulsion obtained in the first step.

For 1 kg of emulsion, 4 g diazo + 5 g aluminium sulphate + 91 g demineralised water must be added. Mix until fully blended, then dilute with demineralised water until the mixture is brought to the application viscosity, generally corresponding to a water content from 5% to 10%, and then leave to rest for a few hours (generally at least 4 hours) to allow dispersion of the air incorporated during agitation, before proceeding with application on the cylinder.

The photosensitive mixture prepared as above (emulsion + diazo + demineralised water) can be used within 15 days from the date of preparation.

The emulsion is applied in the known way, for example with a doctor, on the cylinder with an up-down movement or vice versa, at a speed of between 0,067 m/s and 0,01 m/s. With down-up movement the speed is 0,067 m/s and with up-down movement the speed is between 0,0167 and 0,01 m/s.

The cylinder coated as above is left to dry in a forced ventilation oven at a temperature between 25 and 35°C for approximately 1 hour. The cylinders prepared in this way can be processed as below, also after a week.

When the cylinder with the emulsion is free from humidity, it can be engraved with a source of ultraviolet light placing the design to be reproduced between the light and the cylinder, or by means of a photographic film or spraying of wax via an inkjet system. Exposure is generally 5 minutes when using a photographic film and xenon lamp, and 3-4 minutes when using wax/inkjet system and halogen lamp.

After exposure to the UV light (2), the emulsion, which has been protected from irradiation of the light by the photographic negative or the wax, is removed by washing wish water at ambient temperature.

After removal using water, of the emulsion not hardened to the light, the emulsion left on the cylinder is finally hardened (polymerisation) by placing it in an oven at a temperature of 180-200°C for 1 hour

This last operation makes the emulsion completely insoluble and gives it the necessary chemical-mechanical resistance to printing.

The cylinders thus obtained according to the invention have shown that they possess improved properties with respect to the reference, analogous to those shown by the photosensitive composition of example 2.

## Claims

1. A photosensitive composition comprising a first component containing a resin and a second component containing a sensitizer, to be mixed together, wherein said first component is an emulsion component including polyvinyl alcohol (PVA) and one or more synthetic resins, **characterised in that** said emulsion component further comprises at least one cross-linking agent for the PVA, and said second component is free of chromium and comprises at least one gelling agent for said PVA and at least one photosensitive organic compound, said cross-linking agent being selected from alkylated melamines, alkylated ureic resins, imino melamines, benzoguanamine ressins glycol uryl compounds and said gelling agent being selected from glyoxal, glutaraldehyde, aluminium sulphate and ammonium sulphate

2. A composition as claimed in claim 1, wherein said cross-linking agent for the PVA is iso-butoxymethyl methylol urea.

3. A composition as claimed in claim 1 or 2, wherein said cross-linking agent for the PVA is present in a weight percentage from 5% to 20% of the final composition.

4. A composition as claimed in one of claims 1 to 3, wherein said gelling agent is aluminium sulphate.

5. A composition as claimed in one of claims 1 to 4, wherein said gelling agent is present in a weight percentage from 0.2% to 3% of the final composition.

6. A composition as claimed in one of claims 1 to 5, wherein said photosensitive organic compound consists of one or more diazonium salts.

7. A composition as claimed in claim 6, wherein said photosensitive organic compound comprises the condensation product of the 4-diazodiphenylamine sulphate with HCHO in sulphuric acid.

8. A composition as claimed in claim 6 or 7, wherein said photosensitive organic compound is present in a weight percentage from 0.3% to 2% of the final composition.

9. A composition as claimed in one of the preceding claims, wherein the polyvinyl alcohol is present as a solution containing from 12% to 35% in weight of PVA in water and said solution is present in a weight percentage between 25% and 70% in weight of the final composition.

10. A composition as claimed in claim 1, wherein said one or more synthetic resins include at least one solution from 60% to 80% in weight of an epoxy resin in organinc solvent, said solution of epoxy resin in organic solvent is present in a weight percentage from 10% to 25% of the final composition.

11. A composition as claimed in claim 1, wherein said one or more synthetic resins include at least one alkyd resin in form of a solution in organic solvent from 40% to 60% in weight wherein said alkyd resin solution is present in a weight percentage from 5% to 20% of the final composition.

12. A composition as claimed in one of the preceding claims, further comprising a buffer to maintain the pH level between 6.5 and 8.0.

13. A process for the preparation of a photosensitive composition according to one of claims from 1 to 12, comprising the steps of preparing an emulsion component containing PVA, one or more synthetic resins and at least one cross-linking agent for PVA, and of adding to said emulsion component a second component comprising at least one gelling agent for PVA and at least one photosensitive organic compound.

14. Use of a photosensitive composition as claimed in any of claims 1 to 12 for the production of rotary printing cylinders.

15. A rotary printing cylinder partially provided with a polymerised coating as obtainable from the composition according to any claim 1 to 12.

16. Use of the printing cylinders according to claim 15 for the printing of textile products.

## Patentansprüche

1. Eine lichtempfindliche Zusammensetzung enthaltend eine erste Komponente enthaltend ein Harz und eine zweite Komponente enthaltend einen Sensibilisator, zur Vermischung miteinander, wobei die erste Komponente eine Emulsionskomponente ist enthaltend Polyvinylalkohol (PVA) und eine oder mehrere synthetische Harze, **dadurch gekennzeichnet, dass** die Emulsionskomponente weiterhin mindestens ein Vernetzungsmittel für den PVA enthält, und wobei die zweite Komponente frei von Chrom ist und mindestens einen Gelbildner für den PVA und mindestens eine lichtempfindliche organische Verbindung enthält, wobei das Vernetzungsmittel ausgewählt ist aus alkylierten Melaminen, alkylierten Harnstoffharzen, Iminomelaminen, Benzoguanaminharzen, Glycoluryl-Verbindungen, und wobei der Gelbildner ausgewählt ist aus Glyoxal, Glutaraldehyd, Aluminiumsulfat und Ammoniumsulfat.

2. Eine Zusammensetzung gemäß Anspruch 1, wobei das Vernetzungsmittel für den PVA Isobutoxymethyl-Methylol-Harnstoff ist.

3. Eine Zusammensetzung gemäß Anspruch 1 oder 2, wobei das Vernetzungsmittel für den PVA in einer Konzentration von 5 Gew.-% bis 20 Gew.-% der Endzusammensetzung enthalten ist.

4. Eine Zusammensetzung gemäß einem der Ansprüche 1 bis 3, wobei der Gelbildner Aluminiumsulfat ist.

5. Eine Zusammensetzung gemäß einem der Ansprüche 1 bis 4, wobei der Gelbildner in einer Konzentration von 0,2 Gew.-% bis 3 Gew.-% der Endzusammensetzung enthalten ist.

6. Eine Zusammensetzung gemäß einem der Ansprüche 1 bis 5, wobei die lichtempfindliche organische Verbindung aus einem oder mehreren Diazoniumsalzen besteht.

7. Eine Zusammensetzung gemäß Anspruch 6, wobei die lichtempfindliche organische Verbindung das Kondensationsprodukt von 4-Diazodiphenylaminsulfat und HCHO in Schwefelsäure enthält.

8. Eine Zusammensetzung gemäß Anspruch 6 oder 7, wobei die lichtempfindliche organische Verbindung in einer Konzentration von 0,3 Gew.-% bis 2 Gew.-% der Endzusammensetzung enthalten ist.

9. Eine Zusammensetzung gemäß einem der vorherigen Ansprüche, wobei der Polyvinylalkohol als Lösung enthaltend von 12 Gew.-% bis 35 Gew.-% PVA in Wasser enthalten ist und die Lösung in einer Konzentration zwischen 25 Gew.-% und 70 Gew.-% der Endzusammensetzung enthalten ist.

10. Eine Zusammensetzung gemäß Anspruch 1, wobei das eine oder die mehreren synthetischen Harze mindestens eine Lösung von 60 Gew.-% bis 80 Gew.-% eines Epoxidharzes in einem organischen Lösungsmittel beinhaltet, wobei die Lösung eines Epoxidharzes in einem organischen Lösungsmittel in einer Konzentration von 10 Gew.-% bis 25 Gew.-% der Endzusammensetzung enthalten ist.

11. Eine Zusammensetzung gemäß Anspruch 1, wobei das eine oder die mehreren synthetischen Harze mindestens ein Alkyd-Harz in Farm einer Lösung in einem organischen Lösungsmittel in einer Konzentration von 40 Gew.-% bis 60 Gew.-% einschließt, wobei die Alkydharz-Lösung in einer Konzentration von 5 Gew.-% bis 20 Gew.-% der Endzusammensetzung enthalten ist.

12. Eine Zusammensetzung gemäß einem der vorherigen Ansprüche, weiterhin enthaltend einen Puffer zur Aufrechterhaltung des pH-Wertes zwischen 6,5 und 8,0.

13. Ein Verfahren zur Herstellung einer lichtempfindlichen Zusammensetzung gemäß einem der Ansprüche 1 bis 12, enthaltend die Schritte der Herstellung einer Emulsionskomponente enthaltend PVA, eine oder mehrere synthetische Harze und mindestens ein Vernetzungsmittel für PVA, und Zugeben einer zweiten Komponente enthaltend mindestens einen Gelbildner für den PVA und mindestens eine lichtempfindliche organische Verbindung zu der Emulsionskomponente.

14. Verwendung einer lichtempfindlichen Zusammensetzung gemäß einem der Ansprüche 1 bis 12 zur Herstellung von Rotationsdruckwalzen.

15. Eine Rotationsdruckwalze, die teilweise mit einer polymerisierten Beschichtung versehen ist, die aus der Zusammensetzung gemäß einem der Ansprüche 1 bis 12 erhältlich ist.

16. Verwendung der Rotationsdruckwalzen gemäß Anspruch 15 für das Bedrucken von Textilprodukten.

## Revendications

1. Composition photosensible comprenant un premier composant contenant une résine et un second composant contenant un sensibilisateur, à mélanger ensemble, dans laquelle ledit premier composant est un composant en émulsion comprenant un poly(alcool vinylique) (PVA) et une ou plusieurs résines synthétiques, **caractérisé en ce que** ledit composant en émulsion comprend en outre au moins un agent de réticulation pour le PVA, et ledit second composant est exempt de chrome et comprend au moins un agent gélifiant pour ledit PVA et au moins un composé organique photosensible, ledit agent de réticulation étant choisi parmi les mélamines alkylées, les résines uréiques alkylées, les iminomélamines, les résines de benzoguanamines, les composés de glycolurile, et ledit agent gélifiant étant choisi parmi le glyoxal, le glutaraldéhyde, le sulfate d'aluminium et le sulfate d'ammonium.

2. Composition selon la revendication 1, dans laquelle ledit agent de réticulation pour le PVA est l'iso-butoxyméthyl méthylol urée.

3. Composition selon la revendication 1 ou 2, dans laquelle ledit agent de réticulation pour le PVA est présent à un pourcentage en poids de 5 % à 20 % de la composition finale.

4. Composition selon l'une quelconque des revendications 1 à 3, dans laquelle ledit agent gélifiant est le sulfate d'aluminium.

5. Composition selon l'une quelconque des revendications 1 à 4, dans laquelle ledit agent gélifiant est présent à un pourcentage en poids de 0,2 % à 3 % de la composition finale.

6. Composition selon l'une quelconque des revendications 1 à 5, dans laquelle ledit composé organique photosensible consiste en un ou plusieurs sels de diazonium.

7. Composition selon la revendication 6, dans laquelle ledit composé organique photosensible comprend le produit de condensation entre le sulfate de 4-diazo-diphénylamine et HCHO dans l'acide sulfurique.

8. Composition selon la revendication 6 ou 7, dans laquelle ledit composé organique photosensible est présent à un pourcentage en poids de 0,3 % à 2 % de la composition finale.

9. Composition selon l'une quelconque des revendications précédentes, dans laquelle le poly(alcool vinylique) est présent sous la forme d'une solution contenant 12 % à 35 % en poids de PVA dans l'eau et ladite solution est présente à un pourcentage en poids situé entre 25 % % et 70 % en poids de la composition finale.

10. Composition selon la revendication 1, dans laquelle lesdites une ou plusieurs résines synthétiques comprennent au moins une solution de 60 % à 80 % en poids d'une résine époxy dans un solvant organique, ladite solution de résine époxy dans un solvant organique est présente à un pourcentage en poids de 10 % à 25 % de la composition finale.

11. Composition selon la revendication 1, dans laquelle lesdites une ou plusieurs résines synthétiques comprennent au moins une résine alkyde sous la forme d'une solution dans un solvant organique de 40 % à 60 % en poids, dans laquelle ladite solution de résine alkyde est présente à un pourcentage en poids de 5 % à 20 % de la composition finale.

12. Composition selon l'une quelconque des revendications précédentes, comprenant en outre un tampon pour maintenir le pH entre 6,5 et 8,0.

13. Procédé de préparation d'une composition photosensible selon l'une quelconque des revendications 1 à 12, comprenant les étapes de préparation d'un composant en émulsion contenant un PVA, une ou plusieurs résines synthétiques et au moins un agent de réticulation pour le PVA, et d'ajout audit composant en émulsion d'un second composant comprenant au moins un agent gélifiant pour le PVA et au moins un composé organique photosensible.

14. Utilisation d'une composition photosensible selon l'une quelconque des revendications 1 à 12, pour la production de cylindres d'impression en rotative.

15. Cylindre d'impression en rotative partiellement pourvu d'un revêtement polymérisée pouvant être obtenu à partir de la composition selon l'une quelconque des revendications 1 à 12.

16. Utilisation des cylindres d'impression selon la revendication 15, pour l'impression de produits textiles.
